# EUROPEAN PATENT SPECIFICATION

(11) **EP 4 595 055 B1**
(45) Date of publication and mention of the grant of the patent: **28.10.2026**
(21) Application number: 23869639.7
(22) Date of filing: 15.05.2023
(51) Int. Cl.: G11C 11/16, H10N 50/01, H10B 61/00, H10N 50/10, H10N 50/80

(54) **SPIN-ORBIT-TORQUE (SOT) MRAM WITH DOUBLED LAYER OF SOT METAL**
SPIN-ORBIT-DREHMOMENT (SOT)-MRAM MIT DOPPELSCHICHT AUS SOT-METALL
MÉMOIRE VIVE MAGNÉTIQUE (MRAM) À COUPLE DE SPIN-ORBITE (SOT) AVEC DOUBLE COUCHE DE MÉTAL SOT

(30) Priority: 30.09.2022 US 202217956938
(43) Date of publication of application: 06.08.2025
(73) Proprietor: International Business Machines Corporation, Armonk, New York 10504 (US)
(72) Inventor: HASHEMI, Pouya, Yorktown Heights, New York 10598 (US); SAFRANSKI, Christopher, Yorktown Heights, New York 10598 (US)
(74) Representative: IBM United Kingdom Limited
(86) International application number: PCT/CN2023/094118
(87) International publication number: WO 2024/066384

(56) References cited:
- CN-A- 110 197 682
- CN-A- 111 052 398
- CN-A- 111 129 285
- CN-A- 111 682 106
- CN-A- 111 864 060
- US-A1- 2014 127 901
- US-A1- 2016 225 423
- US-A1- 2017 330 070
- US-A1- 2020 083 429
- US-A1- 2020 227 105

## Description

### BACKGROUND

The present invention relates to the electrical, electronic, and computer arts, and more specifically, to fabrication of non-volatile memory.

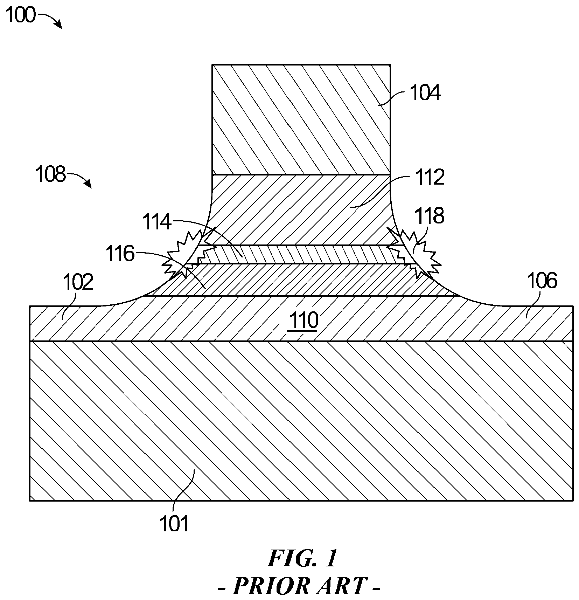

FIG. 1 depicts a main section of spin-orbit-torque (SOT) magnetic random access memory (MRAM memory cell) 100, excluding the bottom electrodes, according to the prior art. The MRAM 100 is formed on a substrate 101. The MRAM 100 includes a top (read) electrode 104, a magnetic tunnel junction (MTJ) stack 108, and a spin-orbit-torque (SOT) layer 110. The SOT layer 110 includes left and right regions 102, 106 that are respectively connected to first (supply) and second (write) bottom electrodes that are out of plane from the drawing view. The MTJ stack 108 includes a pinned layer 112, a barrier layer 114, and a free layer 116. The MRAM 100 SOT induces switching of the free layer 116 (for writing) by injecting an in-plane current from the first bottom electrode to the write electrode in the SOT layer 110 either with or without the assistance of a static in-plane magnetic field. This enables a three terminal MTJ-based concept that isolates the read/write paths, improving the device endurance and read stability. Moreover, due to SOT spin transfer geometry, incubation time is negligible, which allows for reliable switching operation at sub-nanosecond timescales. Examples of prior art documents are US2020/227105A1; US2020/083429A1; US2016/225423A1 and US2014/127901A1.

Occasionally, the MRAM 100 also, undesirably, has metal bridges 118 across edges of the barrier layer 114. The bridges 118 are further discussed below.

### SUMMARY

Principles of the invention provide techniques for spin-orbit-torque (SOT) magnetic random access memory (MRAM) with improved patterning process control. In one aspect, an exemplary magnetic random access memory (MRAM) apparatus includes a magnetic tunnel junction (MTJ) stack; a spin-orbit-torque (SOT) layer that underlies the MTJ stack, wherein the SOT layer has a stepped profile; a dielectric pillar that underlies the SOT layer and the MTJ stack; a dielectric base that surrounds the dielectric pillar; and dielectric bars that protrude from the dielectric base at edges of the SOT layer.

According to another aspect, an exemplary method includes forming a dielectric base of a first dielectric material and a dielectric pillar of a second dielectric material, wherein the dielectric pillar protrudes from the dielectric base; forming a first intermediate structure by depositing a first layer of conductive material onto the dielectric base, sufficiently thick to cover the pillar and the base; forming a planarized structure by planarizing the first intermediate structure to reveal the pillar; and depositing a second layer of spin-orbit-torque metal onto the planarized structure.

In view of the foregoing, techniques of the present invention can provide substantial beneficial technical effects. For example, one or more embodiments provide one or more of:

An SOT MRAM with enhanced reliability due to reducing the presence of metal bridges on the barrier layer.

An SOT MRAM with enhanced switching time due to improved geometry of the SOT layer.

Some embodiments may not have these potential advantages and these potential advantages are not necessarily required of all embodiments. These and other features and advantages of the present invention will become apparent from the following detailed description of illustrative embodiments thereof, which is to be read in connection with the accompanying drawings.

### BRIEF DESCRIPTION OF THE DRAWINGS

FIG. 1 depicts, in a schematic, an SOT MRAM according to the prior art.
FIG. 2 depicts, in a schematic, an SOT MRAM according to exemplary embodiments.
FIG. 3 depicts, in a flowchart, a method for making the SOT MRAM that is shown in FIG. 2.
FIG. 4 through FIG. 9 depict, in schematics, structures that are produced by steps of the method that is shown in FIG. 3. FIG. 5 through FIG. 9 are taken at section line 5 in FIG. 4.
FIG. 10 depicts, in a schematic, an alternate embodiment of the SOT MRAM that is shown in FIG. 2.
FIG. 11 depicts, in a schematic, another alternate embodiment of the SOT MRAM that is shown in FIG. 2.

### DETAILED DESCRIPTION

In fabricating the SOT MRAM 100 that is shown in FIG. 1, according to conventional methods, there is a step of anisotropic etching (typically, reactive ion etch (RIE) or Ion-Beam-Etch (IBE)) in order to define the MTJ stack 108. During the etching step, metal from the SOT layer 110 sputters and redeposits onto edges of the barrier layer 114. The redeposited metal sometimes forms bridges 118, which electrically shorts the barrier layer 114, thereby rendering the MRAM 100 inoperable.

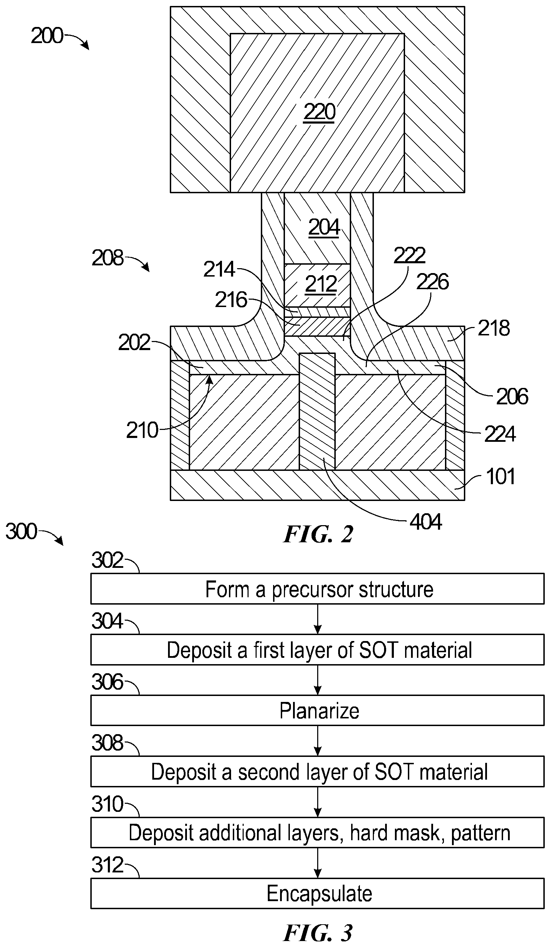

One or more embodiments advantageously provide a method for making an MRAM that in the first instance does not form bridges across the barrier layer, or that eliminates such bridges in case they are formed. Such an SOT MRAM 200 is shown in FIG. 2; unique intermediate and final structures are disclosed herein.

Initial efforts to provide such methods considered the bridges 118 to be an artifact of "under-etch" on the MTJ stack 108 and SOT layer 110. It was believed that additional etching could eliminate the bridges. However, additional etching led to excessive thinning ("over-etch") of the SOT layer 110, which undesirably increase electrical resistance to read and write operations. In contrast, the MRAM 200 advantageously enables additional etching without excessive thinning of its spin-orbit-torque (SOT) layer 210.

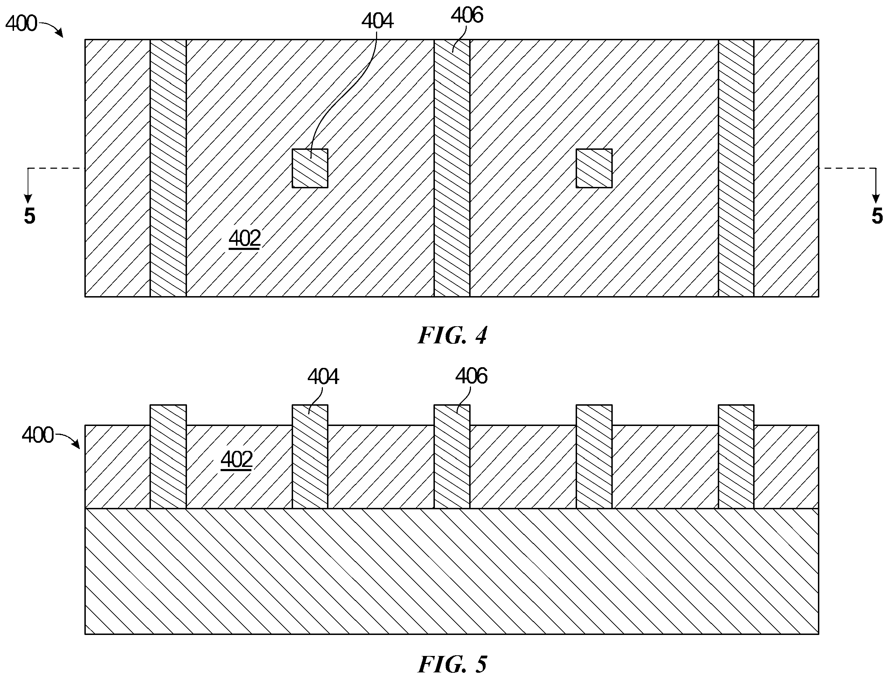

The MRAM 200 includes a top (read) electrode 204, a magnetic tunnel junction (MTJ) stack 208, and the SOT layer 210. The SOT layer 210 includes left and right regions 202, 206 that are respectively connected to first (supply) and second (write) bottom electrodes that are out of plane from the drawing view. The MTJ stack 208 includes a pinned layer 212, a barrier layer 214, and a free layer 216. In the MRAM 200, switching of the free layer 216 (for writing) is induced by injecting an in-plane current through the SOT layer 210 from the supply bottom electrode - to the write electrode, with or without the assistance of a static in-plane magnetic field. The MRAM 200 is disposed atop a dielectric pillar 404, which is further discussed with reference to FIG. 4 and FIG. 5, below. Another dielectric 218 encapsulates the MRAM 200 and insulates it from adjoining memory cells.

Unlike the prior art that is shown in FIG. 1, the SOT layer 210 has a stepped profile with an upper step 222 and lower steps 224 that are joined by risers 226. The steps 222, 224 and the risers 226 are of generally uniform thickness, so that electrical resistance is not impaired. The stepped profile of the SOT layer 210 is produced according to a method 300, which is shown in a flowchart in FIG. 3. Interconnect layer(s) 220 are discussed below.

Semiconductor device manufacturing includes various steps of device patterning processes. For example, the manufacturing of a semiconductor chip may start with a plurality of CAD (computer aided design) generated device patterns, which then are replicated on a substrate. The replication process may involve the use of various exposing techniques and a variety of subtractive (etching) and/or additive (deposition) material processing procedures.

A number of different precursors may be used for the deposition of semiconductor or other materials. In some embodiments, the gas source for the deposition of a material may include silicon (Si) deposited from silane, disilane, trisilane, tetrasilane, hexachlorodisilane, tetrachlorosilane, dichlorosilane, trichlorosilane, disilane and combinations thereof. In other examples, when the material includes germanium, a germanium gas source may be selected from the group consisting of germane, digermane, halogermane, dichlorogermane, trichlorogermane, tetrachlorogermane and combinations thereof. In other examples, when the material includes a metal or a metallic compound, a gas source may include the pure elemental metal, or the metallic compound, as in physical vapor deposition (PVD) / physical vapor transport (PVT) or atomic layer deposition (ALD). Other deposition methods, which also may be suitable for structures that are described herein, include rapid thermal chemical vapor deposition (RTCVD), low-energy plasma deposition (LEPD), ultra-high vacuum chemical vapor deposition (UHVCVD), atmospheric pressure chemical vapor deposition (APCVD) and molecular beam epitaxy (MBE). The various chemical vapor deposition methods typically make use of multiple precursors that react enroute to the deposition surface in order to produce a final composition (which typically has a higher sublimation temperature than the precursors).

Referring to FIG. 3, at 302, form a precursor structure 400, which is shown in FIG. 4 and FIG. 5. The structure 400 includes a first dielectric base 402, as well as a second dielectric that is formed into pillars 404 and bars 406. The pillars 404 will provide the base for copies of the MRAM 200 that is shown in FIG. 2. The pillars 404 and the bars 406 protrude from the base 402. The base 402 is made from a different dielectric than the pillars 404 and the bars 406 so that the base can be etched selective to the pillars and bars. Suitable materials for the base 402 include, e.g., silicon nitride, aluminum oxide, hafnium oxide, and the like.

There are numerous techniques used by those skilled in the art to remove material at various stages of creating a semiconductor structure. As used herein, these processes are referred to generically as "etching". For example, etching includes techniques of wet etching, dry etching, chemical oxide removal (COR) etching, and reactive ion etching (RIE), which are all known techniques to remove select material(s) when forming a semiconductor structure. The Standard Clean 1 (SC1) contains a strong base, typically ammonium hydroxide, and hydrogen peroxide. The SC2 contains a strong acid such as hydrochloric acid and hydrogen peroxide. The techniques and application of etching are well understood by those skilled in the art.

As an exemplary subtractive process, in a photolithographic process, a layer of photo-resist material may first be applied on top of a substrate, and then be exposed selectively according to a pre-determined device pattern or patterns. Portions of the photo-resist that are exposed to light or other ionizing radiation (e.g., ultraviolet, electron beams, X-rays, etc.) may experience some changes in their solubility to certain solutions. The photo-resist may then be developed in a developer solution, thereby removing the non-irradiated (in a negative resist) or irradiated (in a positive resist) portions of the resist layer, to create a photo-resist pattern or photo-mask. The photo-resist pattern or photo-mask may subsequently be copied or transferred to the substrate underneath the photo-resist pattern.

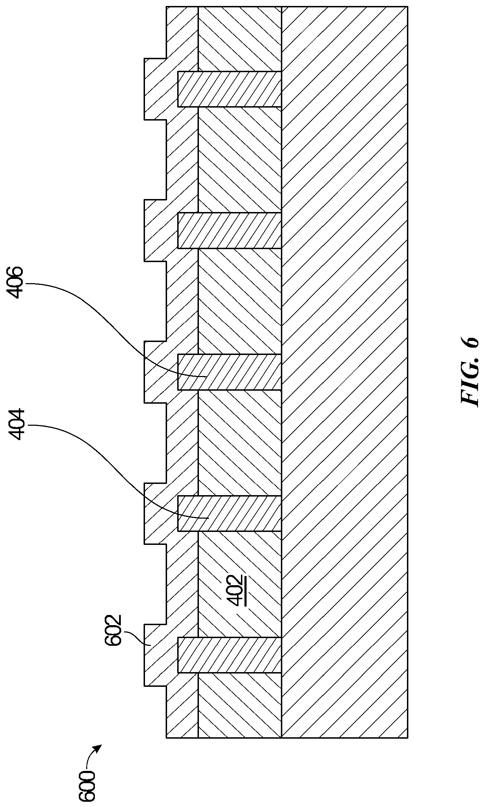

At 304, form a structure 600, which is shown in FIG. 6, by depositing a first layer 602 of material, e.g., spin-orbit-torque metal. The first layer 602 will later form the lower steps 224 that are shown in FIG. 2. In one or more embodiments, suitable SOT materials include, e.g., β-Ta, β-W, CuₓPt₁₋ₓ, Cu₁₋ₓTaₓ, PdₓPt₁₋ₓ, AuₓPt₁₋ₓ, Pt, Bi₂Se₃, WTe₂, PtTe₂, TaS₂, PtₓRh₁₋ₓ or any metallic alloy with average atomic weight above 80. As mentioned, such materials are suitable for deposition by, e.g., PVD, ALD, or MBE. In structure 600, the first layer 602 covers both the pillars 404 and the bars 406.

It should be noted that in certain embodiments, the first layer 602 need not be spin-orbit-torque metal, but could instead be any conductive material that is compatible with the spin-orbit-torque metal.

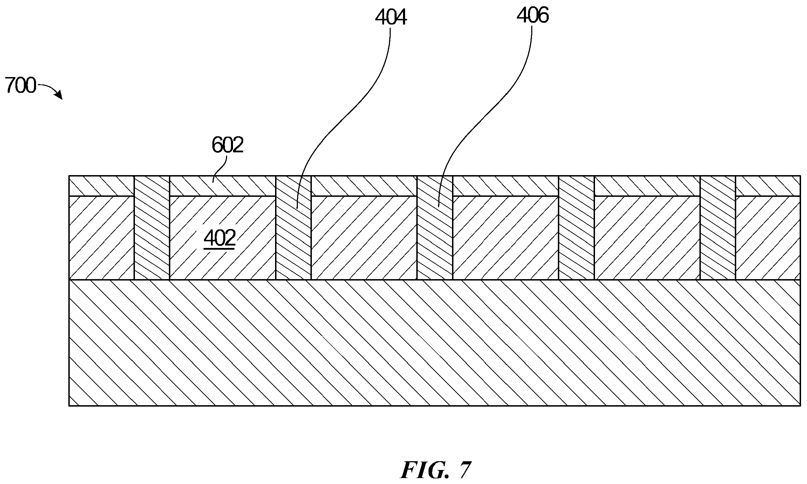

At 306, form a structure 700, which is shown in FIG. 7, by planarizing the structure 600. In one or more embodiments, a method such as chemical-mechanical polishing (CMP) may be used to planarize. In the structure 700, the first layer 602 has been made flush with the tops of the pillars 404 and the bars 406, so that those structures interrupt the first layer 602. Later in the fabrication of the MRAM 200, this results in the bars 406 providing boundaries for the MRAM.

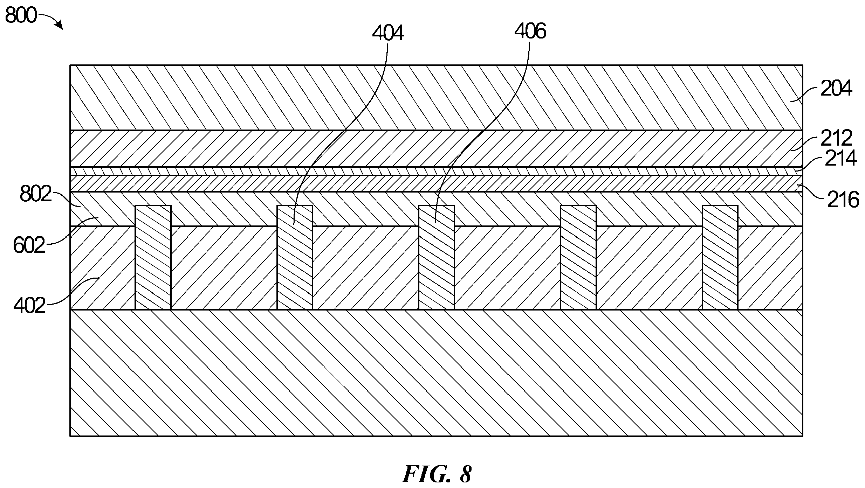

At 308, form a structure 800, which is shown in FIG. 8, by depositing a second layer 802 of SOT material, the free layer 216, the barrier layer 214, the pinned layer 212, and the top electrode 204. The second layer 802 will form the upper step 222 of the SOT layer 210, following additional processing in step 312. For the free layer and the pinned layer, suitable materials include CoFeB or MgO based materials. For the top electrode, suitable materials include TiN, TaN, W, etc. It can be seen that in the structure 800, the second layer 802 covers the bars 406 as well as the pillars 404.

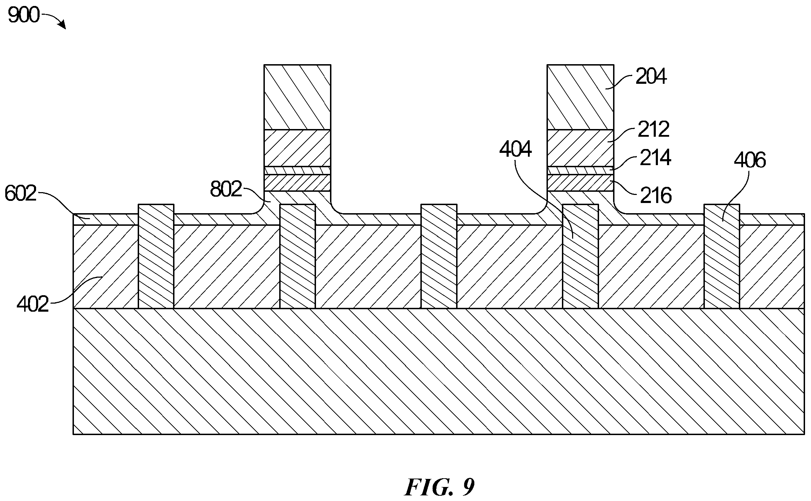

At 310, form a structure 900, which is shown in FIG. 9, by depositing a dielectric hard mask (HM) (SiN, SiOₓ, SiₓB_{y}C_{z}Nₜ, etc.) (not shown) and patterning by lithography, reactive ion etching or ion-beam etching with a stop on the lower step 224 of the SOT layer 210 (seen in FIG. 2). This etching step defines the MTJ stack 208 (seen in FIG. 2). In one or more embodiments, anisotropic etching (e.g., reactive ion etching (RIE) or ion beam etching (IBE)) is used to remove the material in order to reveal the MTJ stack 208. In the prior art, the etching step is where the undesirable bridges 118 often were formed by back-sputtering of etched SOT metal onto the edges of the barrier layer. Back-sputtering is a common side effect of RIE or IBE. However, according to exemplary embodiments, the lower steps 224 of the SOT layer 210 provide additional thickness. Accordingly, it is possible to etch the structure 800 of FIG. 8 sufficiently far down so as to remove any bridges that might otherwise be formed on edges of the barrier layer 214, without impairing (increasing) the electrical resistance of the SOT layer 210 to read and write currents. Additionally, etching the structure 800 results in the SOT layer 210 not covering the bars 406 in the structure 900; thus, as intended, the bars 406 can set boundaries for the MRAM 200.

At 312, complete the MRAM 200 by encapsulating with the dielectric 218 (seen in FIG. 2) and also forming interconnect layers 220 (seen in FIG. 2). The ordinary skilled worker will be familiar with dielectric materials (e.g., silicon oxide, silicon nitride, silicon carbide) and with interconnects, their purposes and shapes, and appropriate interconnect materials (e.g., copper, tungsten, ruthenium, aluminum, silver).

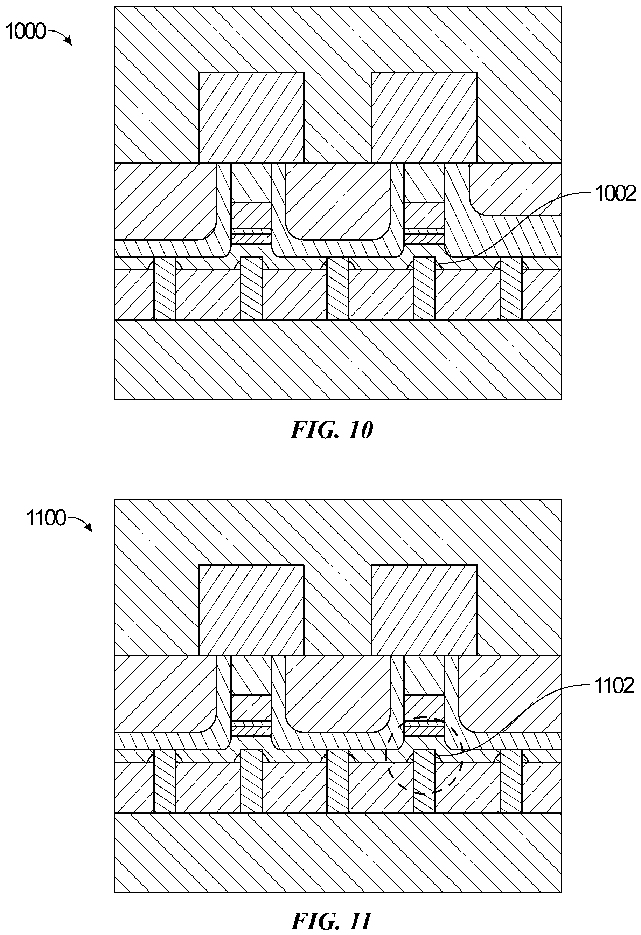

In one or more embodiments, the dielectric pillar 404 may include spacers that further improve uniformity of the thickness of the stepped SOT layer 210. For example, in a structure 1000 as shown in FIG. 10, the pillar 404 may include convex spacers 1002. On the other hand, in a structure 1100 as shown in FIG. 11, the pillar 404 may include concave spacers 1102. The ordinary skilled worker is familiar with methods for forming spacers on the sides of structures during fabrication of semiconductor devices.

Given the discussion thus far, it will be appreciated that, in general terms, an exemplary magnetic random access memory (MRAM) apparatus 200 includes a magnetic tunnel junction (MTJ) stack 208; a spin-orbit-torque (SOT) layer 210 that underlies the MTJ stack, wherein the SOT layer has a stepped profile; and a dielectric pillar 404 that underlies the SOT layer and the MTJ stack.

In one or more embodiments, the MTJ stack includes a pinned layer 212, a barrier layer 214, and a free layer 216. Each layer has horizontal edges, and edges of the barrier layer are free of metal bridges.

In one or more embodiments, the edges of the MTJ stack protrude outward beyond a periphery of the dielectric pillar.

In one or more embodiments, the SOT layer 210 has an upper step 222 directly under the MTJ stack and overlying the dielectric pillar, lower steps 224 below and to either side of the upper step, and risers 226 that connect the lower steps to the upper step.

In one or more embodiments, the dielectric pillar has spacers 1002 at a top end thereof, and the spacers impose a convex shape on the risers. In one or more embodiments, the dielectric pillar has spacers 1102 at a top end thereof, and the spacers impose a concave shape on the risers.

In one or more embodiments, the lower steps of the SOT layer have upper surfaces that are flush with an upper surface of the dielectric pillar, while the upper step of the SOT layer is coextensive with the MTJ stack.

In one or more embodiments, the lower steps of the SOT layer are of a same thickness as the upper step of the SOT layer. In one or more embodiments, the risers of the SOT layer are of a same thickness as the lower steps and the upper step. In one or more embodiments, the upper and lower steps and the risers all are composed of a same material.

The apparatus also includes a dielectric base 402 that surrounds the dielectric pillar; and dielectric bars 406 that protrude from the dielectric base at edges of the SOT layer 210.

According to another aspect, an exemplary method 300 includes, at 302, forming a dielectric base 402 of a first dielectric material and a dielectric pillar 404 of a second dielectric material, wherein the dielectric pillar protrudes from the dielectric base; at 304, forming a first intermediate structure by depositing a first layer 602 of conductive material onto the dielectric base, sufficiently thick to cover the pillar and the base; at 306, forming a planarized structure 700 by planarizing the first intermediate structure to reveal the pillar; and, at 308, depositing a second layer of spin-orbit-torque metal 802 onto the planarized structure.

In one or more embodiments, the method 300 also includes, at 310, depositing additional layers onto the second layer of spin-orbit-torque metal, wherein the additional layers comprise a free layer, a barrier layer, and a pinned layer; and forming a magnetic tunnel junction stack atop the pillar, without bridges on edges of the barrier layer, by etching the additional layers and the second layer of spin-orbit-torque metal around the pillar.

In one or more embodiments, the method also includes etching through the second layer of spin-orbit-torque metal down to the first layer of spin-orbit-torque metal. In one or more embodiments, the method also includes etching into the first layer of spin-orbit-torque metal.

In one or more embodiments, etching the additional layers and the second layer of spin-orbit-torque metal includes etching the additional layers with at least one first ion; and etching the second layer of spin-orbit-torque metal with a second ion that is different than any of the at least one first ions.

In one or more embodiments, the method also includes, before depositing the first layer of spin-orbit-torque metal, forming spacers at a protruding upper end of the pillar. In one or more embodiments, forming spacers includes forming convex spacers. In one or more embodiments, forming spacers includes forming concave spacers.

According to another aspect, an exemplary magnetic random access memory (MRAM) apparatus includes a magnetic tunnel junction (MTJ) stack 208; and a spin-orbit-torque (SOT) layer 210 underlying the MTJ stack. The SOT layer 210 has an upper step 222 directly under the MTJ stack and a lower step 224 adjacent to and below the upper step. The upper step comprises spin-orbit-torque metal.

In one or more embodiments, the lower step of the SOT layer comprises spin-orbit-torque metal. In one or more embodiments, the upper and lower steps of the SOT layer are of uniform thickness. In one or more embodiments, the upper step of the SOT layer is coextensive with the MTJ stack.

In one or more embodiments, the apparatus also includes a dielectric base 402 that underlies the lower step of the SOT layer; and a dielectric pillar 404 that protrudes from the dielectric base beneath the MTJ stack and the upper step of the SOT layer. In one or more embodiments, the apparatus also includes dielectric bars 406 that protrude from the dielectric base at edges of the lower step of the MTJ stack.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope of the invention, which is defined by the appended claims. The terminology used herein was chosen to best explain the principles of the embodiments, the practical application or technical improvement over technologies found in the marketplace, or to enable others of ordinary skill in the art to understand the embodiments disclosed herein. In a preferred embodiment of the present invention described herein, there is provided a magnetic random access memory (MRAM) apparatus comprising: a magnetic tunnel junction (MTJ) stack; and a spin-orbit-torque (SOT) layer underlying the MTJ stack, wherein the SOT layer has an upper step directly under the MTJ stack and a lower step adjacent to and below the upper step, wherein the upper step comprises spin-orbit-torque metal. The lower step of the SOT layer may comprise spin-orbit-torque metal. The upper and lower steps of the SOT layer may be of uniform thickness. The upper step of the SOT layer may be coextensive with the MTJ stack. The apparatus further comprises: a dielectric base that underlies the lower step of the SOT layer; a dielectric pillar that protrudes from the dielectric base beneath the MTJ stack and the upper step of the SOT layer; and dielectric bars that protrude from the dielectric base at edges of the lower step of the MTJ stack.

## Claims

1. A magnetic random access memory, MRAM, apparatus (200, 1000, 1100) comprising:
a magnetic tunnel junction, MTJ, stack (208);
a spin-orbit-torque, SOT, layer (210) that underlies the MTJ stack, wherein the SOT layer has a stepped profile;
a dielectric pillar (404) that underlies the SOT layer and the MTJ stack;
a dielectric base (402) that surrounds the dielectric pillar; and
dielectric bars (406) that protrude from the dielectric base at edges of the SOT layer.

2. The apparatus of claim 1, wherein the MTJ stack comprises a pinned layer (212), a barrier layer (214), and a free layer (216), wherein each layer has horizontal edges, and wherein edges of the barrier layer are free of metal bridges (118).

3. The apparatus of claim 2, wherein the edges of the MTJ stack protrude outward beyond a periphery of the dielectric pillar.

4. The apparatus of claim 1, wherein the SOT layer comprises an upper step (222) directly under the MTJ stack anc overlying the dielectric pillar, lower steps (224) below and to either side of the upper step, and risers (226) that connect the lower steps to the upper step.

5. The apparatus of claim 4, wherein the dielectric pillar comprises spacers (1002; 1102) at a top end thereof, and whereir the spacers impose one of a convex shape and a concave shape on the risers.

6. The apparatus of claim 4, wherein the lower steps of the SOT layer have upper surfaces that are flush with an upper surface of the dielectric pillar, while the upper step of the SOT layer is coextensive with the MTJ stack.

7. The apparatus of claim 6, wherein the lower steps of the SOT layer are of a same thickness as the upper step of the SOT layer.

8. The apparatus of claim 6, wherein the risers of the SOT layer are of a same thickness as the lower steps and the upper step.

9. A method (300) comprising:
forming (302) a dielectric base (402) of a first dielectric material and a dielectric pillar (404) of a second dielectric material wherein the dielectric pillar protrudes from the dielectric base;
forming (304) a first intermediate structure (600) by depositing a first layer (602) of conductive material onto the dielectric base, sufficiently thick to cover the dielectric pillar and the dielectric base;
forming a planarized structure (700) by planarizing (306) the first intermediate structure to reveal the dielectric pillar; **characterized by**
depositing (308) a second layer (802) of spin-orbit-torque metal onto the planarized structure

10. The method of claim 9, further comprising:
depositing (310) additional layers onto the second layer of spin-orbit-torque metal, wherein the additional layers comprise a free layer (216), a barrier layer (214), and a pinned layer (212); and
forming a magnetic tunnel junction stack (208) atop the dielectric pillar, without bridges (118) on edges of the barrier layer, by etching the additional layers and the second layer of spin-orbit-torque metal around the dielectric pillar

11. The method of claim 10, further comprising:
etching through the second layer of spin-orbit-torque metal down to the first layer of conductive material.

12. The method of claim 11, further comprising:
etching into the first layer of conductive material.

13. The method of claim 10, wherein etching the additional layers and the second layer of spin-orbit-torque metal comprises:
etching the additional layers with at least one first ion; and
etching the second layer of spin-orbit-torque metal with a second ion that is different than any of the at least one first ions.

14. The method of claim 10, further comprising:
before depositing the first layer of spin-orbit-torque metal, forming spacers (1002; 1102) at a protruding upper end of the dielectric pillar.

15. The method of claim 14, wherein forming spacers comprises forming one of convex and concave spacers.

## Patentansprüche

1. Vorrichtung eines magnetischen Direktzugriffsspeichers, MRAM-Vorrichtung (200, 1000, 1100), aufweisend:
einen Magnettunnelübergangs-Stapel, MTJ-Stapel (208);
eine Spin-Orbit-Torque-Schicht, SOT-Schicht (210), welche unter dem MTJ-Stapel liegt, wobei die SOT-Schicht ein gestuftes Profil aufweist;
eine dielektrische Säule (404), welche unter der SOT-Schicht und dem MTJ-Stapel liegt;
eine dielektrische Basis (402), welche die dielektrische Säule umgibt; und
dielektrische Stäbe (406) welche an Rändern der SOT-Schicht von der dielektrischen Basis vorstehen.

2. Vorrichtung nach Anspruch 1, wobei der MTJ-Stapel eine gepinnte Schicht (212), eine Barriereschicht (214) und eine freie Schicht (216) aufweist,
wobei jede Schicht horizontale Ränder aufweist und wobei Ränder der Barriereschicht frei von Metallbrücken (118) sind.

3. Vorrichtung nach Anspruch 2, wobei die Ränder des MTJ-Stapels über einen Umfang der dielektrischen Säule hinaus nach außen vorstehen.

4. Vorrichtung nach Anspruch 1, wobei die SOT-Schicht eine obere Stufe (222) direkt unter dem MTJ-Stapel und über der dielektrischen Säule liegend, untere Stufen (224) unterhalb und auf jeder Seite der oberen Stufe und Steigungsbereiche (226) aufweist, welche die unteren Stufen mit der oberen Stufe verbinden.

5. Vorrichtung nach Anspruch 4, wobei die dielektrische Säule Abstandhalter (1002; 1102) an einem oberen Ende davon aufweist und wobei die Abstandhalter den Steigungsbereichen eine aus einer konvexen Form und einer konkaven Form auferlegen.

6. Vorrichtung nach Anspruch 4, wobei die unteren Stufen der SOT-Schicht obere Flächen aufweisen, welche mit einer oberen Fläche der dielektrischen Säule bündig abschließen, während die obere Stufe der SOT-Schicht mit dem MTJ-Stapel deckungsgleich ist.

7. Vorrichtung nach Anspruch 6, wobei die unteren Stufen der SOT-Schicht eine gleiche Dicke wie die obere Stufe der SOT-Schicht aufweisen.

8. Vorrichtung nach Anspruch 6, wobei die Steigungsbereiche der SOT-Schicht eine gleiche Dicke wie die unteren Stufen und die obere Stufe aufweisen.

9. Verfahren (300), umfassend:
Bilden (302) einer dielektrischen Basis (402) eines ersten Dielektrikumsmaterials und einer dielektrischen Säule (404) eines zweiten Dielektrikumsmaterials, wobei die dielektrische Säule von der dielektrischen Basis vorsteht;
Bilden (304) einer ersten Zwischenstruktur (600) durch Abscheiden einer ersten Schicht (602) von leitfähigem Material auf der dielektrischen Basis, ausreichend dick, um die dielektrische Säule und die dielektrische Basis zu bedecken;
Bilden einer planarisierten Struktur (700) durch Planarisieren (306) der ersten Zwischenstruktur, um die dielektrische Säule freizulegen; **gekennzeichnet durch**
Abscheiden (308) einer zweiten Schicht (802) von Spin-Orbit-Torque-Metall auf die planarisierte Struktur.

10. Verfahren nach Anspruch 9, ferner umfassend:
Abscheiden (310) weiterer Schichten auf die zweite Schicht von Spin-Orbit-Torque-Metall, wobei die weiteren Schichten eine freie Schicht (216), eine Barriereschicht (214) und eine gepinnte Schicht (212) umfassen; und
Bilden eines Magnettunnelübergangs-Stapels (208) oben auf der dielektrischen Säule ohne Brücken (118) an Rändern der Barriereschicht durch Ätzen der weiteren Schichten und der zweiten Schicht von Spin-Orbit-Torque-Metall um die dielektrische Säule herum.

11. Verfahren nach Anspruch 10, ferner umfassend:
Ätzen durch die zweite Schicht von Spin-Orbit-Torque-Metall herunter bis zu der ersten Schicht von leitfähigem Material.

12. Verfahren nach Anspruch 11, ferner umfassend:
Ätzen in die erste Schicht von leitfähigem Material.

13. Verfahren nach Anspruch 10, wobei das Ätzen der weiteren Schichten und der zweiten Schicht von Spin-Orbit-Torque-Metall umfasst:
Ätzen der weiteren Schichten mit mindestens einem ersten Ion; und
Ätzen der zweiten Schicht von Spin-Orbit-Torque-Metall mit einem zweiten Ion, welches ein anderes ist als jedes Ion von dem mindestens einen ersten Ion.

14. Verfahren nach Anspruch 10, ferner umfassend:
Bilden von Abstandhaltern (1002; 1102) an einem vorstehenden oberen Ende der dielektrischen Säule vor dem Abscheiden der ersten Schicht von Spin-Orbit-Torque-Metall.

15. Verfahren nach Anspruch 14, wobei das Bilden der Abstandhalter Bilden von einem aus konvexen und konkaven Abstandhaltern umfasst.

## Revendications

1. Appareil de mémoire vive magnétique, MRAM (200, 1000, 1100) comprenant :
un empilement de jonction à effet tunnel magnétique, MTJ (208) ;
une couche à couple spin-orbite, SOT (210) qui est sous-jacente à l'empilement MTJ, dans lequel la couche SOT a un profil étagé ;
un pilier diélectrique (404) qui est sous-jacent à la couche SOT et à l'empilement MTJ ;
une base diélectrique (402) qui entoure le pilier diélectrique ; et
des barres diélectriques (406) qui font saillie à partir de la base diélectrique au niveau de bords de la couche SOT.

2. Appareil selon la revendication 1, dans lequel l'empilement MTJ comprend une couche fixée (212), une couche barrière (214) et une couche libre (216),
dans lequel chaque couche a des bords horizontaux, et dans lequel des bords de la couche barrière sont exempts de ponts métalliques (118).

3. Appareil selon la revendication 2, dans lequel les bords de l'empilement MTJ font saillie vers l'extérieur au-delà d'une périphérie du pilier diélectrique.

4. Appareil selon la revendication 1, dans lequel la couche SOT comprend un étage supérieur (222) directement en-dessous de l'empilement MTJ et sus-jacente au pilier diélectrique, des étages inférieurs (224) en-dessous et de chaque côté de l'étage supérieur et des contremarches (226) qui relient les étages inférieurs à l'étage supérieur.

5. Appareil selon la revendication 4, dans lequel le pilier diélectrique comprend des espaceurs (1002 ; 1102) à son extrémité supérieure, et dans lequel les espaceurs confèrent soit une forme convexe ou une forme concave aux contremarches.

6. Appareil selon la revendication 4, dans lequel les étages inférieurs de la couche SOT ont des surfaces supérieures qui sont affleurantes à une surface supérieure du pilier diélectrique, tandis que l'étage supérieur de la couche SOT est coextensif avec l'empilement MTJ.

7. Appareil selon la revendication 6, dans lequel les étages inférieurs de la couche SOT ont une même épaisseur que l'étage supérieur de la couche SOT.

8. Appareil selon la revendication 6, dans lequel les contremarches de la couche SOT ont une même épaisseur que dans les étages inférieurs et l'étage supérieur.

9. Procédé (300) comprenant :
la formation (302) d'une base diélectrique (402) d'un premier matériau diélectrique et d'un pilier diélectrique (404) d'un second matériau diélectrique dans lequel le pilier diélectrique fait saillie à partir de la base diélectrique ;
la formation (304) d'une première structure intermédiaire (600) en déposant une première couche (602) de matériau conducteur sur la base diélectrique, suffisamment épaisse pour recouvrir le pilier diélectrique et la base diélectrique ;
la formation d'une structure planarisée (700) en planarisant (306) la première structure intermédiaire pour révéler le pilier diélectrique ;
**caractérisé par**
le dépôt (308) d'une seconde couche (802) de métal à couple spin-orbite sur la structure planarisée.

10. Procédé selon la revendication 9, comprenant en outre :
le dépôt (310) de couches supplémentaires sur la seconde couche de métal à couple spin-orbite, dans lequel les couches supplémentaires comprennent une couche libre (216), une couche barrière (214) et une couche fixée (212) ; et
la formation d'un empilement de jonction à effet tunnel magnétique (208) au-dessus du pilier diélectrique, sans ponts (118) sur des bords de la couche barrière, par la gravure des couches supplémentaires et de la seconde couche de métal à couple spin-orbite autour du pilier diélectrique.

11. Procédé selon la revendication 10, comprenant en outre :
la gravure à travers la seconde couche de métal à couple spin-orbite vers le bas jusqu'à la première couche de matériau conducteur.

12. Procédé selon la revendication 11, comprenant en outre :
la gravure dans la première couche de matériau conducteur.

13. Procédé selon la revendication 10, dans lequel la gravure des couches supplémentaires et de la seconde couche de métal à couple spin-orbite comprend :
la gravure des couches supplémentaires avec au moins un premier ion ; et
la gravure de la seconde couche de métal à couple spin-orbite avec un second ion qui est différent de n'importe lequel des premiers ions.

14. Procédé selon la revendication 10, comprenant en outre :
avant le dépôt de la première couche de métal à couple spin-orbite, la formation d'espaceurs (1002 ; 1102) à une extrémité supérieure en saillie du pilier diélectrique.

15. Procédé selon la revendication 14, dans lequel la formation d'espaceurs comprend la formation soit d'un espace convexe ou d'un espaceur concave.
